# EUROPÄISCHE PATENTSCHRIFT

(11) **EP 0 470 367 B1**
(45) Veröffentlichungstag und Bekanntmachung des Hinweises auf die Patenterteilung: **26.04.1995**
(21) Anmeldenummer: 91110994.0
(22) Anmeldetag: 03.07.1991
(51) Int. Cl.: G01R 27/22, G01N 27/02

(54) **Vorrichtung zur Messung der Leitfähigkeit von Flüssigkeiten**
Device for measuring the conductivity of fluids
Dispositif de mesure de la conductivité des fluides

(30) Priorität: 08.08.1990 DE 4025091
(43) Veröffentlichungstag der Anmeldung: 12.02.1992
(73) Patentinhaber: Schilling, Gerhard, D-71665 Vaihingen (DE)
(72) Erfinder: Dorsch, Manfred, Prof.Dipl.-Ing., W-6962 Adelsheim (DE); Szulerecki, Gregor Alexander, Dipl.-Ing., W-7100 Heilbronn (DE); Haak, Kurt, W-7129 Ilsfeld-Auenstein (DE)
(74) Vertreter: Clemens, Gerhard, Dr.-Ing.

(56) Entgegenhaltungen:
- DE-A- 1 598 075
- DE-A- 2 822 943
- GB-A- 2 064 127
- US-A- 2 542 057
- US-A- 3 292 077
- US-A- 3 419 796
- US-A- 4 220 920
- ISA TRANSACTIONS. Bd. 27, Nr. 2, 1988, RES. TRI. PARK, US Seiten 37 - 42; J.E.DOWNEY, JR.: 'A New, High-Temperature Electrodeless Conductivity Sensor'
- ISA TRANSACTIONS. Bd. 21, Nr. 4, 1982, RES. TRI. PARK, US Seiten 63 - 70; R.SHAW ET. AL.: 'On-Line Analysis of Oleum Using Electrodeless Conductivity'

## Beschreibung

Die Erfindung betrifft eine Vorrichtung zur Messung der Leitfähikeit von Flüssigkeiten, mit zwei ringförmigen Kernen aus magnetisierbarem Material, die, bezogen auf eine Achse, koaxial zueinander angeordnet sind, wobei auf diese Kerne je eine sich nur über einen engen Umfangssektor erstreckende Wicklung aufgewickelt ist und mit einer diese Kerne durchsetzenden Meßmediumssäule, die Teil eines geschlossenen, beide Kerne gemeinsam umschlingenden und koppelnden elektrischen Leiters ist.

Ringförmige Kerne können rund oder nach Art eines Vielecks, zum Beispiel eines Quadrates, ausgebildet sein. Vorzugsweise haben die Kerne die Form eines Kreisringes.

Bei Vorrichtungen der eingangs genannten Art wird die Wicklung des einen, des primären Kerns mit einer Erregerwechselspannung erregt, die in der Wicklung des anderen, des sekundären Kerns eine Meßspannung induziert, deren Amplitude von der Leitfähigkeit der Flüssigkeitssäule abhängt und als Maß für die elektrolytische Leitfähigkeit der Flüssigkeit dienen kann.

Bei einer aus der DE-OS 2822943 bekannten Vorrichtung sind die beiden Wicklungen im wesentlichen achsparallel zueinander angeordnet. Bei der achsparallelen Ausrichtung der Wicklungen sind diese induktiv miteinander gekoppelt. Durch eine solche Kopplung wird das angestrebte Meßergebnis überlagert beziehungsweise verfälscht, was sich besonders beim Messen kleiner Leitfähigkeiten nachteilig auswirkt.

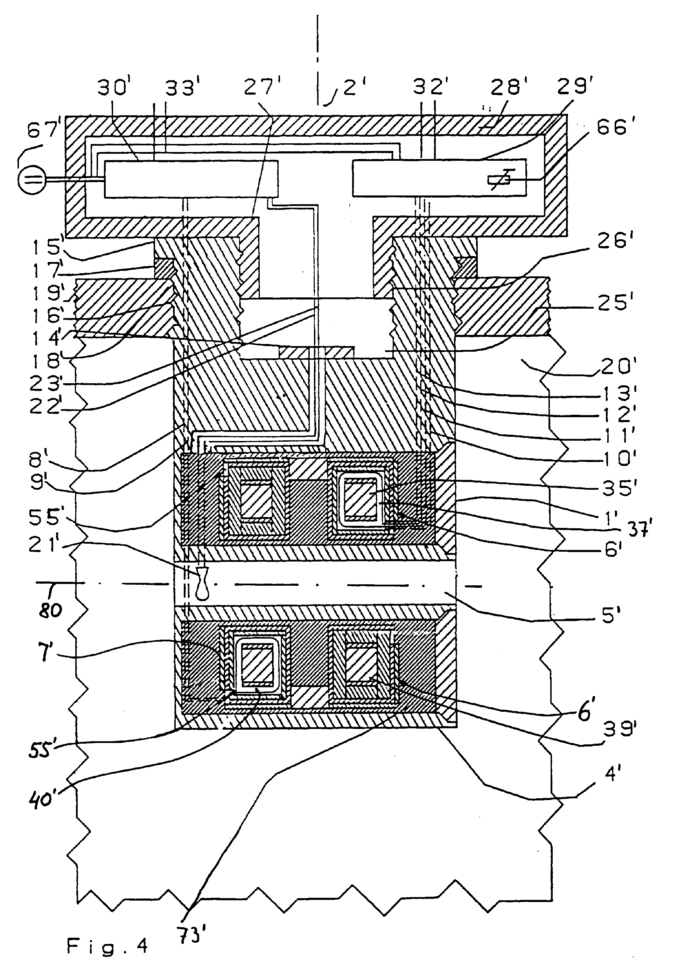

DE-A-1 598 075 offenbart eine Anordnung zur Konzentrationsbestimmung von Elektrolyten durch elektrodenlose Leitfähigkeitsmessung und zielt darauf ab, das Vorsehen von aufwendig stabilisierten Oszillatoren und Verstärkern zu vermeiden. Dabei wird vorgeschlagen, eine die Magnetisierung des zweiten Transformators kompensierende Wicklung dieses Transformators vom Ausgang eines elektronischen Multiplikators, vorzugsweise eines Hall-Multiplikators, zu speisen, dessen erster Eingang mit einer weiteren Wicklung des in der Flüssigkeitsschleife die Spannung induzierenden ersten Transformators verbunden ist, während dem zweiten Eingang des Multiplikators der gleichgerichtete und gesiebte Strom eines Verstärkers zugeführt wird, dessen Eingang an einer Wicklung des zweiten Transformators liegt. Dabei sind zwei Kerne aus magnetisierbarem Material vorhanden, die nebeneinander angeordnet sind, wobei auf jedem kreisförmigen Kern jeweils zwei Wicklungsbereiche vorhanden sind. Hierbei kann es zu einer gegenseitigen Beeinflußung der Wicklungen kommen, so daß die Genauigkeit der Meßergebnisse nicht optimal ist. Gemäß Figur 4 dieser Anordnung können die Kerne auch übereinanderliegend angeordnet sein.

Der vorliegenden Erfindung liegt die Aufgabe zugrunde, eine Vorrichtung der eingangs genannten Art so auszugestalten, daß sie eine möglichst genaue Messung der Leitfähigkeit, insbesondere auch bei kleinen Leitfähigkeiten, gestattet und gleichzeitig bei Verwendung von Kernmaterial minderer Qualität gute Meßergebnisse gewährleistet.

Die Erfindung ist durch die Merkmale des Anspruchs 1 gegeben. Sie zeichnet sich dadurch aus, daß die Mitteltangenten der beiden, den Wicklungen zugeordneten Umfangssektoren auf beiden koaxial übereinander angeordneten Kernen, bezogenauf einen Schnitt senkrecht zur Achse, rechtwinklig zueinander angeordnet sind.

Als Meßmedien kommen in erster Linie Flüssigkeiten in Betracht. Die Erfindung ist aber auch anwendbar auf breiige, schüttfähige und auch auf feste Meßmedien.

Bei einem kreisrunden Kern, der bevorzugt eingesetzt wird, erstreckt sich die Meßwicklung nur über einen möglichst engen Umfangssektor. Die Wicklungen werden vorzugsweise direkt auf den Kern gewickelt. Im Rahmen der Krümmung des betreffenden Umfangssektors ist die Wicklung dann aber entsprechend dem Kern gekrümmt. Daher können die beiden Wicklungen in diesem Fall nicht streng geometrisch rechtwinklig zueinander angeordnet sein. Die Mitteltangenten der beiden den Wicklungen zugeordneten Umfangssektoren stehen aber streng geometrisch rechtwinklig aufeinander. In diesem Sinne ist es zu verstehen, wenn hier und im folgenden von "im wesentlichen rechtwinklig" gesprochen wird.

Man kann auch auf einem gekrümmten Kernsektor eine gerade Wicklung wickeln, indem man diese auf einen geraden Zylindermantel wickelt, der sich achsparallel zur Mitteltangente des zugeordneten Umfangssektors erstreckt. Wenn man das bei beiden Kernen macht, kann man eine streng rechtwinklige Anordnung der Wicklungen zueinander erzielen. Das führt aber zu einer sehr aufwendigen Wickeltechnik und zu einer Benachteiligung der angestrebten induktiven Wirkung dieser Wicklungen.

Man kann die beiden Kerne so anordnen, daß der eine Kern den anderen auf gleicher axialer Höhe umgibt. Bevorzugt ist jedoch demgegenüber eine Anordnung wie sie auch aus der zitierten DE-OS 2822943 bekannt ist, bei der die beiden Kerne entlang ihrer Ringachse versetzt übereinander angeordnet und vorzugsweise gleich groß sind.

Nach der DE-OS 2822943 ist ein Aluminiumblech vorgesehen, das die beiden Wicklungen gemeinsam nach allen Seiten abschirmt.

Aufgabe einer Weiterbildung ist es darüberhinaus, die gegenseitige, kapazitive Beeinflussung der Wicklungen, die zu Meßfehlern führen kann, zu vermeiden. Dies wird dadurch erzielt, daß für mindestens einen der Kerne Mantel, vorzugsweise für beide Kerne je ein Mantel, aus Kupfer oder dergleichen elektrisch leitfähigem aber nicht ferromagnetischem Abschirmmaterial vorgesehen ist, in dem der betreffende Kern mitsamt seiner Wicklung untergebracht ist, während der andere Kern außerhalb dieses Behälters angeordnet ist.

In einem solchen Mantel könnten Kurzschlußströme induziert werden, die zu Verlusten und Meßfehlern führen. Das wird dadurch vermieden, daß mindestens einer der Abschirmmäntel bis auf einen beziehungsweise je einen zur zugehörigen Ringachse koaxialen Schlitz geschlossen ist.

Durch die Schlitze werden Kurzschlußströme unterbunden, aber es wird auch die angestrebte kapazitive Abschirmung unterbrochen. Die unerwünschte Wirkung dieser Unterbrechung kann man dadurch minimieren, daß für beide Kerne je ein Abschirmmantel aus Abschirmmaterial vorgesehen sind, daß die Schlitze an der dem jeweils anderen Kern abgekehrten Seite des Behälters, und zwar für den einen Abschirmmantel radial außen und für den anderen Abschirmmantel radial innen, angeordnet sind. Dann liegen die beiden Schlitze, bezogen auf den axialen Querschnitt beider Kerne diagonal versetzt maximal weit auseinander und auf einander gegenüberliegenden Seiten.

Zwischen den Kernen besteht unmittelbar eine unerwünschte magnetische Kopplung, die ebenfalls, insbesondere bei kleinen Leitfähigkeiten, die Meßergebnisse stört. Dieser Kopplung kann man dadurch entgegenwirken, daß zur magnetischen Abschirmung die einander abgekehrten Seiten der Kerne und die der Flüssigkeitssäule abgekehrten Außenseiten der Kerne mit einer Abschirmfolie aus Mumetall oder dergleichen Material hoher Permeabilität beschichtet sind.

Die Permeabilität des eingesetzten Kernmaterials ist abhängig von der Kerntemperatur. Diese Abhängigkeit ist besonders groß, wenn man aus Kostengründen einfaches Kernmaterial einsetzt. Diese Abhängigkeit kann man elektrisch bei der Auswertung der Meßwerte kompensieren. Zu diesem Zweck empfiehlt es sich, daß mindestens an einem der Kerne, vorzugsweise an dem sekundär geschalteten, ein Temperaturmeßfühler, vorzugsweise ein thermoempfindlicher Widerstand, in unmittelbarem Berührungskontakt mit dem Kernmaterial angeordnet ist und mit dessen Temperaturmeßsignalen eine Kompensationsschaltung angesteuert wird.

Man kann auch an beiden Kernen je einen Temperaturmeßfühler anordnen und beide Temperaturwerte zur Kompensation heranziehen.

Die Massenproduktion wird erleichtert, wenn jeder der Kerne mit seinen Wicklungen und seinen Abschirmungen und dem gegebenenfalls vorgesehenen Temperaturmeßfühler als handliches Einbauteil, ausgebildet ist, in das die Zuleitungen von außen münden, die vorzugsweise durch die Schlitze geführt sind. Ein solches Einbauteil weist vorzugsweise von außen sichtbare Kennungen für die Winkelorientierung des mit den Wicklungen belegten Umfangssektors auf, damit die Bauteile mit rechtwinklig zueinander orientierten Wicklungen eingebaut werden können.

Für den Einsatz der Vorrichtung als Meßsonde ist ein bequemer nachträglicher Einbau in vorhandene Tanks oder dergleichen wünschenswert. Dem wird eine bevorzugte Ausgestaltung der Erfindung gerecht, die dadurch gekennzeichnet ist, daß die beiden Kerne mit ihren Wicklungen ihren Abschirmungen und ihren elektrischen Anschlüssen in einen gemeinsamen zylinderförmigen Sondenkörper eingegossen sind und daß für die Meßmediumsäule eine den Sondenkörper durchsetzenden Meßmediumleitung vorgesehen ist, die sich mindestens mit einem Abschnitt geradlinig und koaxial zu den Kernen erstreckt, daß ein Temperaturmeßfühler in der Meßmediumleitung vorgesehen ist. Dabei empfiehlt es sich, daß elektrische Anschlußleitungen, für die Wicklungen und die Temperaturmeßfühler am Ende des Sondenkörpers herausgeführt sind und daß der Sondenkörper an diesem Ende in eine meßmediumdichte Durchführung durch eine einen Meßmediumbehälter begrenzende Wand von außen einschraubbar ausgerüstet ist.

Bei der aus der DE-OS 2822943 bekannten Vorrichtung ist der entsprechende Sondenkörper in den Deckel eines Flüssigkeitstanks eingepaßt und die Primärwicklung wird von einem Generator angesteuert, der in Abhängigkeit von dem in die Flüssigkeitsleitung eintauchenden Temperaturmeßfühler betrieben wird. Für die Sekundärwicklungen ist eine Auswertschaltung innerhalb des Sondenkörpers angeordnet, an die ein außen angeordnetes Anzeigeinstrument für die Meßspannung angeschlossen ist. Das Meßgerät zeigt mithin nicht die Leitfähigkeit, sondern eine von der Leitfähigkeit nach Maßgabe der Flüssigkeitstemperatur abgeleitete Größe, zum Beispiel, den Salzgehalt an. Dagegen wird nach der bevorzugten Ausgestaltung ein Signal für die Leitfähigkeit und ein zweites Signal für die Flüssigkeitstemperatur erzeugt. Aus diesen beiden Signalen kann in nachgeordneten Rechnerschaltungen nach Maßgabe der jeweils untersuchten Flüssigkeit der Salzgehalt oder dergleichen abgeleitete Größe errechnet werden.

Für den Anschluß an eine solche Rechnerschaltung rüstet man eine Sonde zweckmäßig derart aus, daß am anderen Ende des Sondenkörpers ein Gehäuse mit einer ersten elektronischen Auswertschaltung für die Leitfähigkeitsmessung und einer zweiten elektronischen Auswertschaltung für die Lösungsmitteltemperatur befestigt ist und daß die elektrischen Anschlußleitungen für die Wicklungen und den mindestens an einem Kern angeordneten Temperaturmeßfühler zu der ersten Auswertschaltung und die Anschlußleitung für den in der Meßmediumleitung vorgesehenen Temperaturmeßfühler an die zweite Auswertschaltung führen.

Die Erfindung wird nun anhand der beigefügten Zeichnung näher erläutert.

In der Zeichnung zeigt:
- Figur 1: eine Vorrichtung zum Messen und Anzeigen der Leitfähigkeit und der Temperatur einer Flüssigkeit in Betriebsstellung eingebaut und zwar im Schnitt der, wie durch die Schnittpfeile Ia und Ib aus Figur 2 angezeigt um 90 Grad abgewinkelt ist,
- Figur 2: die beiden Kerne aus Figur 1 mit ihren Wicklungen in der Ansicht gemäß dem Pfeil II aus Figur 1, wobei der obere Kern aufgebrochen ist, so daß die Wicklung des unteren Kerns sichtbar wird,
- Figur 3: das den oberen Kern aus Figur 1 enthaltende Bauteil in der Schnittansicht gemäß Figur 1 in größerem Maßstab herausgezeichnet und
- Figur 4: im Schnitt eine gegenüber Figur 1 abgeänderte Vorrichtung.

In der Zeichnung ist mit 1 ein zur Achse 2 kreiszylinderförmiger Sondenkörper bezeichnet, der aus gegen die zu messende Flüssigkeit hinreichend widerstandsfähigem Kunststoff besteht. In diesen Sondenkörper ist eine zur Achse 2 koaxiale Steigleitung 3 eingelassen, die von der Stirnseite 4 am einen Ende des Sondenkörpers ausgeht und in eine quer den Sondenkörper durchsetzende Querleitung 5 T-förmig mündet.

Koaxial zur Achse 2 sind in Achsrichtung nebeneinander zwei ringförmige Kernbauteile 6 und 7 in den Kunststoff des Sondenkörpers eingelassen. Die elektrischen Anschlußleitungen 8 bis 13 dieser Kernbauteile sind in den Kunststoff des Sondenkörpers eingelassen verlegt und an eine am anderen Ende des Sondenkörpers angeordnete Kupplung 14 angeschlossen.

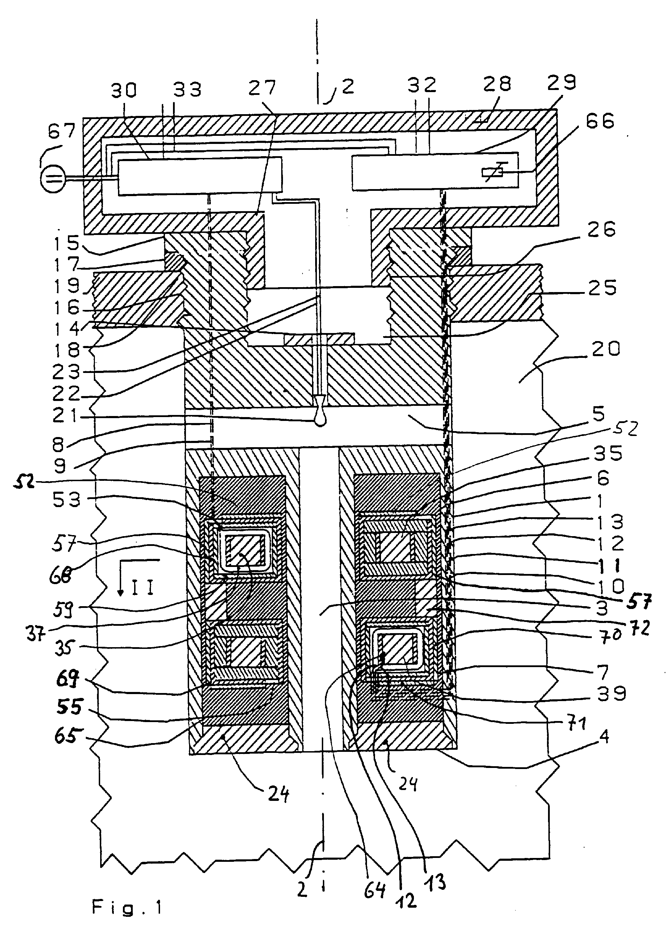

An diesem in Figur 1 oben gezeichneten Ende ist ein nach außen ragender Flansch 15 vorgesehen, an den sich ein Außengewinde 16 anschließt, mit dem der Sondenkörper unter Zwischenlage eines Dichtringes 17 von außen in eine vorgesehene Gewindebohrung 18 in der Wand 19 eines Flüssigkeitstanks 20 eingeschraubt ist.

Der Flüssigkeitstank 20 enthält eine Flüssigkeit, deren elektrolytische Leitfähigkeit gemessen werden soll. Diese Flüssigkeit kommuniziert in der Steigleitung 3 und in der Querleitung 5. Am Kreuzpunkt dieser Leitungen ragt ein Thermomeßfühler 21 in die Flüssigkeit, dessen elektrische Anschlußleitungen 22, 23 an die Kupplung 14 angeschlossen sind.

An seinem oben gezeichneten Ende weist der Sondenkörper ein Sackloch 25 mit Innengewinde 26 auf. In dieses Innengewinde ist das Außengewinde einer Gewindemuffe 27 eingeschraubt. Die Gewindemuffe gehört zu einem Gehäuse 28, innerhalb dessen eine erste elektrische Auswertschaltung 29 für die Leitfähigkeit und eine zweite elektrische Auswertschaltung 30 für die Temperatur der zu messenden Flüssigkeit untergebracht ist.

Das Kernbauteil 6 besteht aus einem ringförmigen zur Achse 2 koaxialen Kern 35 aus hochpermeablem Material. Aus Kostengründen wird Ferrit bevorzugt. Die Nachteile, die durch die gegenüber besseren Materialien geringere Permeabilität und größere Streuung aus Kostengründen in Kauf genommen werden, werden durch vorgesehene Abschirmungen ausgeglichen. Darüberhinaus können zum Ausgleich auch noch elektronische Maßnahmen vorgesehen sein.

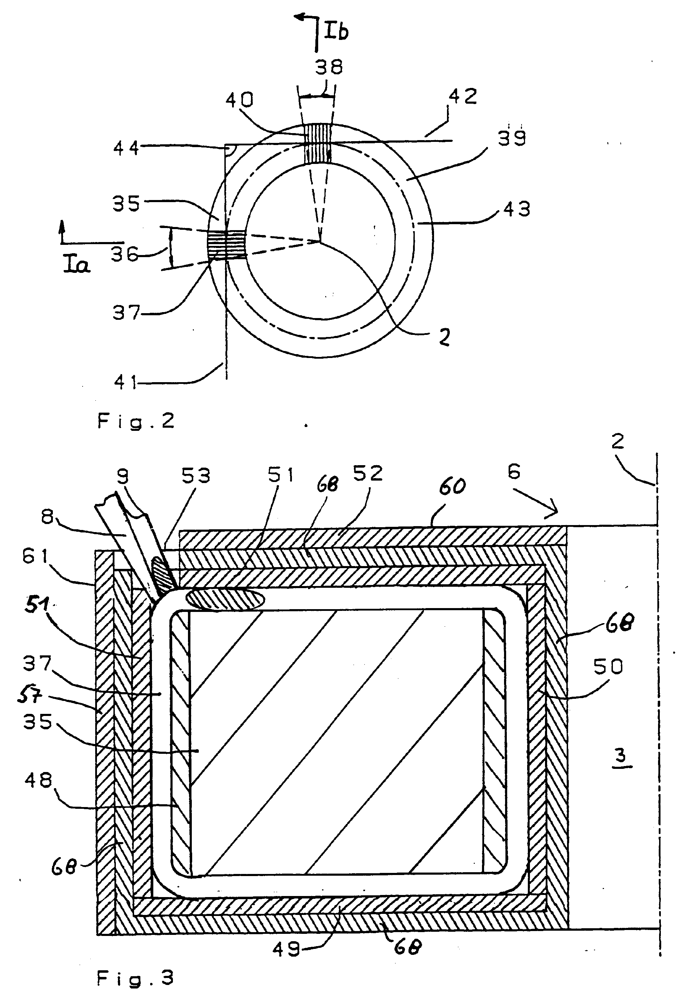

Der Kern 35 ist wie aus Figur 2 ersichtlich auf einem schmalen, sich über 10 bis 20° erstreckenden Umfangssektor 36 mit einer Primärwicklung 37 bewickelt, die unmittelbar auf den Kern aufgewickelt ist, gegebenenfalls unter Zwischenlage einer nur in Figur 1 und 3 eingezeichneten Isolierfolie 48. Entsprechend ist über den Umfangssektor 38 des koaxial darunter gezeichneten Kerns 39 des Kernbauelementes 7 eine Sekundärwicklung 40 gewickelt. Da in einem geraden Längsschnitt die beiden Wicklungen 37, 40 nicht sichtbar wären, ist in Figur 1 der Schnitt entsprechend den Schnittpfeilen Ia und Ib aus Figur 2 gewinkelt und zwar entlang der Achse 2, so daß die abgewinkelte Schnittebene durch beiden Wicklungen 37 und 40 hindurchgeht.

Die Primärwicklung 37 hat beispielsweise 5 Windungen, die Sekundärwicklung 40 beispielsweise 50 Windungen, also etwa zehn mal soviel Wicklungen und benötigt deshalb einen etwas größeren Umfangssektor 38, der sich über 15 bis 25° erstreckt. Auch die Wicklung 40 ist unter Zwischenlage einer nur in Figur 1 dargestellten Isolierfolie direkt auf den Kern gewickelt.

Beide Wicklungen 37 und 40 sind den Krümmungen der Umfangssektoren 36, 38 entsprechend leicht gekrümmt. Sie erstrecken sich aber, bezogen auf die Mitteltangenten der zugehörigen Sektoren 36, 38 an die Mittellinie 43 der Kerne senkrecht zueinander, gemäß dem rechten Winkel 44 aus Figur 2. Durch diese rechtwinklige beziehungsweise im wesentlichen rechtwinklige Anordnung der beiden Wicklungen sind diese maximal induktiv gegeneinander entkoppelt. Die beiden Kernbauteile 6, 7 tragen von außen sichtbare Markierungen, die die Winkellage der Wicklungen der zugehörigen Kerne zeigen und den rechtwinkligen Einbau ermöglichen.

Die Wicklung 37 des Kerns 35 ist an allen vier Seiten mit einer Isolierfolie 48, 49, 50, 51 beschichtet. Mit 68 ist ein Mantel aus Kupferblech von etwa 0,1 mm (Millimeter) Stärke bezeichnet. Dieser Mantel ist ringförmig ausgebildet und umgibt den Kern mit der Primärwicklung 37 vollständig, ausgenommen einen ringförmigen zur Achse 2 koaxialen Schlitz 53, der sich an der dem anderen Kern 39 abgekehrten Seite radial auswärts erstreckt. Im anderen Kernbauteil ist die Wicklung 40 entsprechend isoliert und es ist ein entsprechender ringförmiger Mantel 69 aus Kupfer vorgesehen, der einen zur Achse 2 koaxialen Schlitz 55 aufweist. Der Schlitz 55 erstreckt sich auf der dem Kern 35 abgekehrten Seite radial einwärts, also im Querschnitt aus Figur 1 diagonal dem Schlitz 53 gegenüber. Die Schlitze dienen zur Unterbindung einer induzierten Kurzschlußströmung.

Das Kernbauteil 6 ist an seiner dem anderen Kernbauteil 7 abgekehrten Stirnseite 60 und an seiner Außenseite 61 mit je einer Folie 52, 57 aus hochpermeablem Material, vorzugsweise Mumetall, beschichtet. Eine entsprechende Beschichtung des anderen Kernbauteils 7 ist mit 70, 71 bezeichnet und erstreckt sich über die dem Kernbauteil 6 abgekehrte Stirnseite und die Außenseite. Diese Beschichtungen dienen zur magnetischen Entkopplung der beiden Kerne.

In unmittelbarer Berührung mit dem Kern 39 ist in dem Kernbauteil 7 ein Temperaturmeßfühler 64 angeordnet, dessen elektrische Anschlußleitungen mit 12 und 13 bezeichnet sind. Die Anschlußleitungen 10 bis 13 des Kernbauteils 7 und die Anschlußleitungen 8 und 9 des Kernbauteils 6 sind durch den Schlitz 55 beziehungsweise 53 aus dem betreffenden Bauteil herausgeführt.

Die beiden Kernbauteile 6 und 7 sind in entsprechende ringförmige Aufnahmen des zylindrischen Sondenkörpers 1 eingesetzt. Zwischen den beiden Kernbauteilen ist ein ringförmiger Abstandshalter 72 eingesetzt. Die Aufnahme ist im übrigen mit Vergußmasse 73 ausgefüllt und mit einem ringförmigen Deckel 24 verschlossen.

Die erste Auswertschaltung 29 steuert über die Leitungen 8 und 9 die Primärwicklung des Kernbauteils 6 an und nimmt über die Leitungen 10 und 11 die in der Sekundärwicklung 40 induzierte Spannung ab und wird außerdem von den Signalen des Temperaturmeßfühlers 64 über die Leitungen 12 und 13 beaufschlagt.

Die erste Auswertschaltung 29 weist ein justierbares Schaltungselement 66 auf, das entsprechend den magnetischen Eigenschaften der jeweils eingebauten Kerne, die fertigungsbedingt voneinander abweichen, eingestellt wird. Die Auswertschaltung 29 errechnet aus den eingespeisten Daten ein Ausgangssignal, das eine Funktion, vorzugsweise eine proportionale Funktion, der elektrolytischen Leitfähigkeit der gemessenen Flüssigkeit ist und an der Ausgangsleitung 32 abgegeben wird.

Die zweite Auswertschaltung 30 wird über die Leitungen 22, 23 von den Temperaturmeßwerten des Temperaturmeßwertfühlers 21 angesteuert und gibt ein Signal ab, das eine Funktion, vorzugsweise eine proportionale Funktion, der Temperatur der gemessenen Flüssigkeit ist und der Ausgangsleitung 33 abgegeben wird.

Die Signale auf beiden Ausgangsleitungen 32, 33 sind frequenzcodiert.

Die beiden Auswertschaltungen 29 und 30 sind an eine äußere Stromquelle 67 angeschlossen.

Die Ausgangssignale der Ausgangsleitungen 32 und 33 können einen nachgeordneten Rechner ansteuern, der in Abhängigkeit von diesen Signalen nach einem, von der jeweiligen Flüssigkeit abhängigen, vorgebenen Programm, den Salzgehalt der Flüssigkeit errechnet.

Das zweite, in Figur 4 dargestellte Ausführungsbeispiel unterscheidet sich nur in einigen Details von dem ersten Ausführungsbeispiel. Die Teile, die in beiden Ausführungsbeispielen einander entsprechen, sind deshalb mit gleichen Bezugsziffern bezeichnet, in Figur 4 jedoch mit einem nachgesetzten Strich. Nachfolgend werden nur die Unterschiede erläutert, darüberhinaus ist für das Ausführungsbeispiel nach Figur 4 auch die Beschreibung für Figur 1 zu lesen.

Nach Figur 4 wird der Sondenkörper 1 von einem geraden Querkanal 5′ senkrecht zur Achse 2 durchsetzt. Koaxial zur Achse 80 des Querkanals 5′ sind die Kernbauteile 6′, 7′ angeordnet. Damit beide Wicklungen 37′ und 40′ in Figur 4 sichtbar sind, ist der dargestellt Längsschnitt entlang der Achse 80 um 90 Grad abgewinkelt. Die in der Zeichenebene der Figur 4 geschnitten sichtbaren Wicklungen 37′ und 40′ sind also tatsächlich, wie auch beim ersten Ausführungsbeispiel und wie für die Wicklungen 37, 40 aus Figur 2 ersichtlich um 90 Grad und nicht etwa um 180 Grad gegeneinander versetzt.

Der Thermofühler 21′ ist am einen Ende der Querleitung 5′ angeordnet. Im Gegensatz zu der Ausführungsform nach Figur 1 ergibt sich für das Meßmedium eine gerade durch den Sondenkörper gehende Leitung, während nach Figur 1 das Meßmedium im Winkel durch den Sondenkörper fließt, um in die Steigleitung 3 zu gelangen.

Die Ausführungsform nach Figur 4 bietet den Vorteil, daß man die Flüssigkeitsleitung, da sie gerade ist, besser reinigen kann und man kann leichter steife Meßmedien vermessen und zähflüssige oder nur schüttfähige Meßmedien besser durch den Sondenkörper treiben.

Im übrigen ist das Ausführungsbeispiel nach Figur 4 genauso ausgebildet und wird auch genauso betrieben, wie das zuerst beschriebene Ausführungsbeispiel.

## Patentansprüche

1. Vorrichtung zur Messung der Leitfähigkeit von Flüssigkeiten,
- mit zwei ringförmigen Kernen (35, 39) aus magnetisierbarem Material, die, bezogen auf eine Achse (2), koaxial zueinander angeordnet sind, wobei auf diese Kerne (35, 39) je eine sich nur über einen engen Umfangssektor (36, 38) erstreckende Wicklung (37, 40) aufgewickelt ist und
- mit einer diese Kerne (35, 39) durchsetzenden Meßmediumssäule (3), die Teil eines geschlossenen, beide Kerne (35, 39) gemeinsam umschlingenden und koppelnden elektrischen Leiters ist,
**dadurch gekennzeichnet**, daß
- die Mitteltangenten (41, 42) der beiden, den Wicklungen (37, 40) zugeordneten Umfangssektoren (36, 38) auf beiden koaxial übereinander angeordneten Kernen (35, 39), bezogen auf einen Schnitt senkrecht zur Achse (2), rechtwinklig zueinander angeordnet sind.

2. Vorrichtung nach Anspruch 1, dadurch gekennzeichnet,
daß zur kapazitiven Abschirmung für mindestens einen der Kerne ( 35, 39 ) ein Mantel ( 68, 69 ) aus Kupfer oder dergleichen elektrisch leitfähigem aber nicht ferromagnetischem Abschirmmaterial vorgesehen ist, in dem der betreffende Kern mitsamt seiner Wicklung untergebrachtist, während der andere Kern außerhalb dieses aus dem Abschirmmaterial hergestellten Behälters angeordnet ist.

3. Vorrichtung nach Anspruch 2, dadurch gekennzeichnet,
daß mindestens einer der Abschirmmäntel ( 68, 69 ) bis auf einen beziehungsweise je einen zur zugehörigen Achse ( 2 ) koaxialen Schlitz ( 53, 55 ) geschlossen ist.

4. Vorrichtung nach Anspruch 3, dadurch gekennzeichnet,
daß für beide Kerne ( 35, 39 ) je ein Abschirmmantel ( 68, 69 ) aus Abschirmmaterial vorgesehen sind,
daß die Schlitze ( 53, 55 ) an der dem jeweils anderen Kern abgekehrten Seite des Behälters, und zwar für den einen Abschirmmantel ( 68 ) radial außen und für den anderen Abschirmmantel ( 69 ) radial innen, angeordnet sind.

5. Vorrichtung nach einem der vorhergehenden Ansprüche, dadurch gekennzeichnet,
daß zur magnetischen Abschirmung die einander abgekehrten Seiten der Kerne ( 35, 39 ) beziehungsweise der Abschirmmäntel ( 68, 69 ) und die der Achse ( 2 ) abgekehrten Außenseiten der Kerne mit einer Abschirmfolie ( 52, 57, 70, 71, ... ) aus Mumetall oder dergleichen Material hoher Permeabilität beschichtet sind.

6. Vorrichtung nach einem der vorhergehenden Ansprüche, dadurch gekennzeichnet,
daß mindestens an dem einen Kern ( 39 ), vorzugsweise an dem sekundär geschalteten, ein Temperaturmeßfühler ( 64 ), vorzugsweise ein thermoempfindlicher Widerstand, angeordnet ist.

7. Vorrichtung nach einem der vorhergehenden Ansprüche, dadurch gekennzeichnet,
daß jeder der Kerne ( 35, 39 ) mit seinen Wicklungen ( 37, 40 ) und seinen Abschirmungen ( 48, 50, 52, 68, ...) als handliches Einbauteil, ausgebildet ist, in das Zuleitungen ( 8, 9 ) von außen münden, die vorzugsweise durch die Schlitze ( 53, 55) geführt sind.

8. Vorrichtung nach einem der vorhergehenden Ansprüche, dadurch gekennzeichnet,
daß die beiden Kerne ( 35, 39 ) mit ihren Wicklungen ( 37, 40 ), ihren Abschirmungen ( 48, 50, 52, 68, ...) und ihren elektrischen Anschlüssen ( 8 - 13 ) in einen gemeinsamen zylinderförmigen Sondenkörper ( 1 ) eingegossen sind und
daß für die Meßmediumsäule eine den Sondenkörper durchsetzenden Meßmediumleitung ( 3 ) vorgesehen ist, die sich mindestens mit einem Abschnitt geradlinig und koaxial zu den Kernen erstreckt.

9. Vorrichtung nach Anspruch 8, dadurch gekennzeichnet,
daß ein Temperaturmeßfühler ( 21 ) in der Meßmediumleitung ( 3 ) vorgesehen ist,
daß elektrische Anschlußleitungen ( 8 - 13, 22, 23 ) für die Wicklungen ( 37, 40 ) und die Temperaturmeßfühler ( 64, 21 ) am Ende des Sondenkörpers herausgeführt sind und
daß der Sondenkörper an diesem Ende in eine meßmediumdichte Durchführung ( 18 ) durch eine einen Meßmediumbehälter ( 20 ) begrenzende Wand ( 19 ) von außen einschraubbar ausgerüstet ist.

10. Vorrichtung nach Anspruch 7, 8 oder 9, dadurch gekennzeichnet,
daß am anderen Ende des Sondenkörpers ( 1 ) ein Gehäuse ( 28 ) mit einer ersten elektronischen Auswertschaltung ( 29 ) für die Leitfähigkeitsmessung und einer zweiten elektronischen Auswertschaltung ( 30 ) für die Lösungsmitteltemperatur befestigt ist und
daß die elektrischen Anschlußleitungen ( 8 - 13 ) für die Wicklungen ( 37, 40 ) und den mindestens an einem Kern ( 39 ) angeordneten Temperaturmeßfühler ( 64 ) zu der ersten Auswertschaltung ( 29 ) und die Anschlußleitung ( 22, 23 ) für den in der Meßmediumleitung ( 3 ) vorgesehenen Temperatürmeßfühler ( 21 ) an die zweite Auswertschaltung ( 30 ) führen.

## Claims

1. Device for measuring the conductivity of liquids,
- having two annular cores (35, 39) made from magnetizable material which, referred to an axis (2), are arranged coaxially with one another, a winding (37, 40) extending only over a narrow circumferential sector (36, 38) being respectively wound onto these cores (35, 39), and
- having a measuring medium column (3) which penetrates these cores (35, 39) and is a part of a closed electric conductor which wraps around both cores (35, 39) jointly and couples them,
characterized in that
- the middle tangents (41, 42) of the two circumferential sectors (36, 38) assigned to the windings (37, 40) on the two cores (35, 39) arranged coaxially one above another are arranged at right angles to one another, referred to a section perpendicular to the axis (2).

2. Device according to Claim 1, characterized in that for the purpose of capacitive screening for at least one of the cores (35, 39) provision is made of a jacket (68, 69) made from copper or a similar electrically conductive but not ferromagnetic screening material, in which the relevant core is accommodated together with its winding, while the other core is arranged outside this container produced from the screening material.

3. Device according to Claim 2, characterized in that at least one of the screening jackets (68, 69) is closed except for a slot, or one slot (53, 55) each, which is coaxial with the associated axis (2).

4. Device according to Claim 3, characterized in that a screening jacket (68, 69) made from screening material is provided in each case for the two cores (35, 39), and in that the slots (53, 55) are arranged on the side of the container averted from the respectively other core, specifically radially outwards for one screening jacket (68) and radially inwards for the other screening jacket (69).

5. Device according to one of the preceding claims, characterized in that for the purpose of magnetic screening the mutually averted sides of the cores (35, 39) or of the screening jackets (68, 69) and the outside surfaces of the cores which are averted from the axis (2) are coated with a screening foil (52, 57, 70, 71, ...) made from nickel iron or a similar material of high permeability.

6. Device according to one of the preceding claims, characterized in that a temperature sensor (64), preferably a heat-sensitive resistor, is arranged at least on one core (39), preferably on that connected as the secondary core.

7. Device according to one of the preceding claims, characterized in that each of the cores (35, 39) is constructed with its windings (37, 40) and its screens (48, 50, 52, 68, ...) as a handy built-in component into which supply leads, which are preferably led through the slots (53, 55), open from outside.

8. Device according to one of the preceding claims, characterized in that the two cores (35, 39) with their windings (37, 40), their screens (48, 50, 52, 68, ...) and their electrical connections (8 - 13) are cast into a common cylindrical probe body (1), and in that there is provided for the measuring medium column a measuring medium line (3) which penetrates the probe body and extends at least with a section rectilinearly and coaxially with the cores.

9. Device according to Claim 8, characterized in that a temperature sensor (21) is provided in the measuring medium line (3), in that electric connecting leads (8 - 13, 22, 23) for the windings (37, 40) and the temperature sensors (64, 21) are led out at the end of the probe body, and in that the probe body is fitted at this end in such a way that it can be screwed from outside into a bushing (18), tight with respect to the measuring medium, through a wall (19) bounding a measuring medium container (20).

10. Device according to Claim 7, 8 or 9, characterized in that attached to the other end of the probe body (1) is a housing (28) having a first electronic evaluation circuit (29) for measuring conductivity and a second electronic evaluation circuit (30) for the solvent temperature, and in that the electric connecting leads (8 - 13) for the windings (37, 40) and the temperature sensor (64) arranged at least on one core (39) lead to the first evaluation circuit (29), and the connecting lead (22, 23) for the temperature sensor (21) provided in the measuring medium line (3) leads to the second evaluation circuit (30).

## Revendications

1. Dispositif de mesure de la conductivité de liquides,
- avec deux noyaux annulaires (35, 39) en matériau magnétisable qui sont coaxiaux par rapport à un axe (2), un bobinage respectif (37, 40) ne s'étendant que sur un étroit secteur circonférentiel (36, 38) étant enroulé sur chacun de ces noyaux (35, 39), et
- avec une colonne de fluide de mesure (3) traversant ces noyaux (35, 39), qui fait partie d'un conducteur électrique fermé couplant et enlaçant conjointement les deux noyaux (35, 39),
**caractérisé** en ce que les tangentes au centre (41, 42) des deux secteurs circonférentiels (36, 38) associés aux bobinages (37, 40) sur les deux noyaux (35,39) disposés coaxialement l'un au-dessus de l'autre sont perpendiculaires dans une coupe orthogonale à l'axe (2).

2. Dispositif selon la revendication 1, **caractérisé** en ce qu'afin de former un écran de blindage capacitif pour au moins un des noyaux (35, 39), il est prévu une enveloppe (68, 69) en cuivre ou autre matériau de blindage similaire électriquement conducteur mais non ferromagnétique, enveloppe dans laquelle est logé le noyau concerné ainsi que son bobinage, tandis que l'autre noyau est disposé à l'extérieur de cette boîte réalisée en matériau de blindage.

3. Dispositif selon la revendication 2, **caractérisé** en ce qu'au moins une des enveloppes de blindage (68,69) est fermée à l'exception d'une fente ou, selon le cas, d'une fente respective (53, 55) coaxiale à l'axe associé (2).

4. Dispositif selon la revendication 3, **caractérisé** en ce qu'une enveloppe de blindage respective (68, 69) en matériau de blindage est prévue pour chacun des deux noyaux (35, 39), et en ce que les fentes (53, 55) sont disposées sur le côté de la boîte qui est chaque fois opposé à l'autre noyau, à savoir radialement à l'extérieur pour une (68) des enveloppes de blindage et radialement à l'intérieur pour l'autre enveloppe de blindage (69).

5. Dispositif selon l'une des revendications précédentes, **caractérisé** en ce qu'afin de réaliser un blindage magnétique, les côtés mutuellement opposés des noyaux (35, 39) ou encore des enveloppes de blindage (68,69), et les côtés extérieurs des noyaux opposés à l'axe (2), sont recouverts d'une feuille de blindage (52, 57, 70, 71, ...) en mumétal ou matériau similaire à haute perméabilité.

6. Dispositif selon l'une des revendications précédentes, **caractérisé** en ce qu'un palpeur de température (64), de préférence une résistance thermosensible, est disposé sur au moins un (39) des noyaux, de préférence sur celui monté comme noyau secondaire.

7. Dispositif selon l'une des revendications précédentes, **caractérisé** en ce que chacun des deux noyaux (35, 39) est réalisé avec ses bobinages (37, 40) et ses blindages (48, 50, 52, 68, ...) sous la forme d'une pièce d'insertion maniable, dans laquelle débouchent des lignes d'alimentation (8, 9) en provenance de l'extérieur, qui passent de préférence par les fentes (53, 55).

8. Dispositif selon l'une des revendications précédentes, **caractérisé** en ce que les deux noyaux (35, 39), avec leurs bobinages (37, 40), leurs blindages (48, 50, 52, 68, ...) et leurs connexions électriques (8-13), sont noyés dans un corps de sonde cylindrique commun (1), et en ce qu'est prévue, pour la colonne de fluide de mesure, une conduite de fluide de mesure (3) traversant le corps de sonde, laquelle s'étend, au moins par un tronçon, en ligne droite et coaxialement aux noyaux.

9. Dispositif selon la revendication 8, **caractérisé** en ce qu'un palpeur de température (21) est prévu dans la conduite de fluide de mesure (3), en ce que des lignes de connexion électrique (8 - 13, 22, 23) pour les bobinages (37, 40) et les palpeurs de température (64, 21) sortent à l'extrémité du corps de sonde, et en ce que le corps de sonde peut, à cette extrémité, être vissé de l'extérieur dans un passage (18), étanche au fluide de mesure, qui est pratiqué dans une paroi (19) délimitant un récipient (20) de fluide de mesure.

10. Dispositif selon l'une des revendications 7, 8, 9, **caractérisé** en ce qu'un boîtier (28) est fixé à l'autre extrémité du corps de sonde (1), avec un premier montage électronique d'interprétation (29) pour la mesure de conductivité et un deuxième montage électronique d'interprétation (30) pour la température de la solution, et en ce que les lignes de connexion électrique (8 - 13) pour les bobinages (37, 40) et le palpeur de température (64) disposé sur au moins un des noyaux mènent au premier montage d'interprétation (29), tandis que la ligne de connexion (22, 23) pour le palpeur de température (21) prévu dans la conduite de fluide de mesure (3) mène au deuxième montage d'interprétation (30).
